# DEMANDE DE BREVET EUROPEEN

(11) **EP 2 075 827 A1**
(43) Date de publication de la demande: **01.07.2009**
(21) Numéro de dépôt: 08305731.5
(22) Date de dépôt: 27.10.2008
(51) Int. Cl.: H01L 21/60

(54) **Procédé de fabrication de billes métalliques par plasma à partir d'une couche comportant plusieurs éléments**

(30) Priorité: 24.12.2007 FR 0760347
(71) Demandeur: Commissariat A L'Energie Atomique - CEA, 75015 Paris (FR)
(72) Inventeur: Grenouillet, Laurent, 38140 Rives (FR); Garcia, Jonathan, 38930 Monestier du Percy (FR); Marion, François, 38950 Saint Martin le Vinoux (FR); Olivier, Nicolas, 38470 Teche (FR); Perrin, Marion, 26000 Valence (FR)
(74) Mandataire: Vuillermoz, Bruno

(57) **Abrégé**

L'invention concerne un procédé de fabrication de billes composées d'au moins un matériau conducteur électrique. Un tel procédé comprend les étapes suivantes :
- dépôt, sur un support, d'un alliage comprenant au moins le matériau conducteur électrique et un second matériau ;
- exposition de l'alliage à une gravure plasma, de manière à entraîner la désorption des matériaux de l'alliage n'entrant pas dans la composition des billes, à savoir au moins le second matériau mais pas le matériau conducteur électrique ;
- formation de billes composées d'au moins ledit matériau conducteur électrique.

## Description

### DOMAINE DE L'INVENTION

La présente invention concerne la fabrication de microbilles métalliques, présentant à la fois une faible taille et une forte densité.

De telles billes trouvent notamment application dans le domaine du « packaging » des composants optoélectroniques et/ou microélectroniques.

Plus précisément, le procédé selon l'invention repose sur l'utilisation d'un alliage, de nature au moins binaire.

### ETAT ANTERIEUR DE LA TECHNIQUE

Dans le domaine des micro- et nano- technologies, la tendance est à la réduction de la taille des composants et à l'augmentation de leur densité d'intégration. Cette tendance doit nécessairement être suivie par les technologies d'interconnexion (films et adhésifs conducteurs, flip chip (1), ...), pour lesquels les pas sont de plus en plus fins.

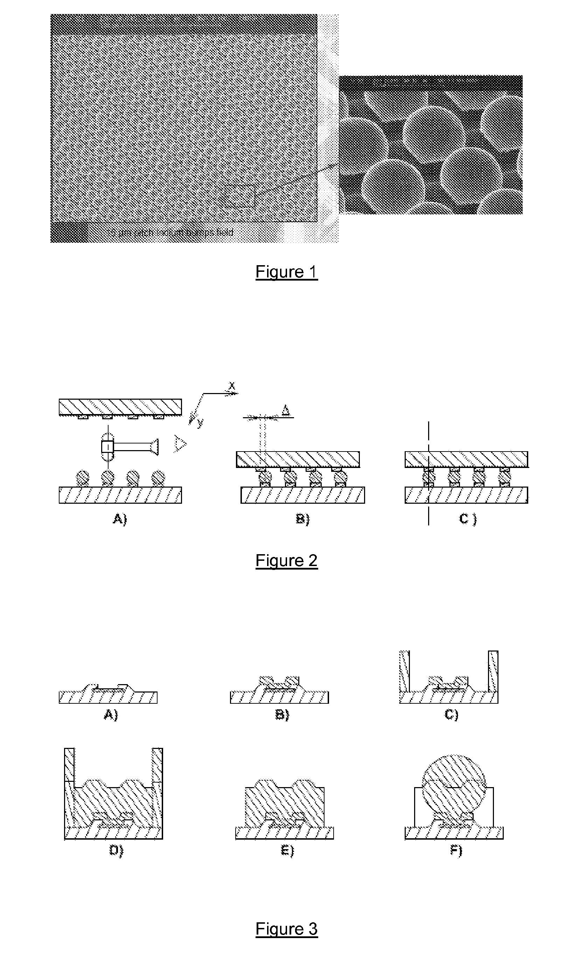

Un premier exemple concerne le « flip-chip » ou « hybridation par billes » qui est une technique très intéressante pour hybrider des composants, par exemple sur des circuits de lecture (Figure 1). Par rapport à d'autres techniques comme le « wire-bonding » (ou « microcâblage »), elle permet d'obtenir une haute efficacité d'interconnexion et de faire fonctionner les composants à haute fréquence. En outre, cette technique collective permet d'obtenir un auto-alignement des composants (Figure 2).

Le mode de réalisation actuel des billes d'indium est explicité à la Figure 3. La quantité de matière nécessaire à la formation de la bille d'indium est déposée par « lift off » ou « dépôt localisé » sur un plot métallique, puis la plaque est portée à une température suffisante pour refondre l'indium : le métal prend alors sa forme de bille.

Ce mode de réalisation fait intervenir une étape technologique délicate, le « lift off », qui nécessite l'emploi de résines épaisses et une bonne maîtrise de leur profil, ainsi qu'une étape de refonte pour obtenir la bille d'indium proprement dite. Le diamètre typique des billes obtenues est de l'ordre de 10 µm, avec un pas de 15 µm, comme illustré à la figure 1. Avec cette technique, l'obtention de billes plus petites, avec des densités importantes, devient difficile.

Pour des pas plus fins et/ou des tailles de billes plus petites, d'autres modes d'obtention, tels que la photolithographie classique avec gravure plasma de l'indium (avec une chimie carbonée) ou la croissance électrolytique, sont utilisés. Cependant, ces modes de réalisation ne sont aujourd'hui pas arrivés à maturité.

Un second exemple concerne le domaine des films/colles conductrices anisotropes. Ces colles contiennent des particules qui, écrasées par thermocompression, vont provoquer une conduction verticale. Dans ce domaine, il faut également mettre en oeuvre des films de plus en plus fins, avec des connectiques de plus en plus denses. Actuellement, les films conducteurs anisotropes (ACF pour « Anisotrope Conductive Films »), qui possèdent les particules conductrices les plus petites, sont des produits avec des particules de diamètre 3 µm.

Le problème technique que se propose de résoudre la présente invention est donc de fournir un procédé permettant la fabrication de microbilles métalliques ayant les caractéristiques structurales souhaitées, en particulier présentant une taille inférieure, et une densité par unité de surface importante.

Un autre objectif avantageusement poursuivi par la présente invention est d'offrir un procédé permettant de s'affranchir des étapes de photolithographie mises en oeuvre dans l'art antérieur.

### EXPOSE DE L'INVENTION

Ainsi l'invention concerne un procédé de fabrication de billes constituées d'au moins un matériau conducteur électrique, à partir d'un alliage composé d'au moins ce premier matériau et au moins un second matériau.

Pour une meilleure compréhension et dans la suite de la description, le premier matériau, conducteur électrique, est noté (A), le second matériau (B) et l'alliage (AB). Le terme d'alliage est approprié dans la mesure où le matériau mixte AB comprend au moins un métal.

Plus précisément, un tel procédé comprend les étapes suivantes :
- le dépôt, sur un support, de l'alliage (AB) comprenant au moins le premier
   (A) et le second matériau (B) ;
- l'exposition de cet alliage (AB) à une gravure plasma, de manière à entraîner la désorption des éléments, à l'exception d'au moins le matériau conducteur électrique (A).

Plus précisément, on entend par « éléments » les matériaux de l'alliage n'entrant pas dans la composition des billes, en l'occurrence le second matériau (B). Au contraire, le matériau conducteur électrique (A) constitutif des billes ne doit pas subir la désorption.

A l'issue de ce procédé, il y a formation sur le substrat de billes composées des matériaux de l'alliage n'ayant pas subi de désorption, en l'occurrence du matériau conducteur électrique (A).

Dans un mode de réalisation privilégié, l'alliage est un matériau binaire constitué de A et B exclusivement. Avantageusement, les matériaux associés sont choisis parmi les éléments des colonnes II et VI ou des colonnes III et V, telles que définies dans la classification périodique.

Comme déjà dit le premier matériau présente la propriété d'être conducteur électrique. Il s'agit donc d'un métal, voire d'un métalloïde.

Avantageusement, le matériau conducteur électrique est de l'indium (In) ou du gallium (Ga) qui sont classés dans la colonne III du tableau périodique.

Ainsi, des matériaux binaires privilégiés sont InP ou GaAs, dans lesquels le phosphore (P) et l'arsenic (As), appartenant à la colonne V du tableau périodique, sont associés au métal In et Ga, et permettent la formation de billes d'indium et de gallium, respectivement.

Un autre exemple de matériau binaire privilégié est du cadmium (Cd ; colonne II du tableau périodique) associé à du tellure (Te ; colonne VI du tableau périodique).

Alternativement, l'alliage peut être de nature ternaire ou quaternaire, comprenant un ou plusieurs matériaux conducteurs électriques. Ainsi, un matériau InAsP permettra la formation de billes d'indium, alors qu'un matériau quaternaire de type InGaAsP donnera lieu a des billes composées soit d'un seul de ces deux métaux (In ou Ga), soit d'un alliage d'indium et de gallium.

Selon l'invention, le matériau conducteur électrique (A), destiné à constituer la bille, n'est donc pas déposé sous sa forme simple comme dans l'art antérieur, mais sous forme d'un matériau au moins binaire (AB).

Cet alliage (AB) peut par exemple être déposé par la méthode de dépôt chimique en phase vapeur (CVD pour « *Chemical Vapor Deposition* »), avantageusement à basse température (entre 100 et 250°C) comme rapporté dans le document US 5,346,852.

Dans ce cas de figure, l'alliage se présente sous la forme d'une couche pleine plaque.

Avantageusement, l'alliage déposé peut être mis en forme par lithographie puis gravure, avant la gravure plasma. La lithographie est avantageusement mise en oeuvre à l'aide d'une résine fine et la gravure est de type chimique ou sèche. Cette variante permet de mieux contrôler d'éventuelles fluctuations en taille des billes formées, dans la mesure où la quantité de matière formant la bille est prédéfinie.

Dans le cadre de la réalisation de films conducteurs anisotropes (ACF), des plots métalliques de connexion sont disposés sur le support, avant de réaliser le dépôt de l'alliage. Avantageusement, ces plots sont espacés et recouverts par le dépôt. A l'issue de la seconde étape qui va être détaillée ci-dessous, des billes métalliques sont donc formées à la surface de ces plots métalliques, assurant la connexion avec les plots métalliques qui viendront en regard.

Dans le cadre de la réalisation de champ de microbilles métalliques (« flip chip »), des plots métalliques sont également disposés sur le support, avec un espacement de l'ordre de 100 nm à quelques micromètres. Ces plots sont voués à être recouverts par le dépôt et sont configurés pour ne permettre la formation que d'une microbille par plot. Ceci dépend notamment de la surface du plot, de la quantité d'alliage déposé.

Dans une étape ultérieure, l'alliage est gravé par plasma. La gravure par plasma a pour but d'enlever de la matière à l'alliage. Les conditions de cette étape sont fixées de manière à obtenir :
- une désorption sélective de tous les éléments à l'exception des éléments souhaités dans la composition de la bille, notamment le matériau conducteur électrique (A) ;
- la formation de billes à l'aide du matériau conducteur électrique (A) présentant les caractéristiques souhaitées, notamment de taille, grâce à sa réorganisation sous forme sphérique à la surface.
   L'étape de gravure plasma est avantageusement réalisée sous un vide de l'ordre de 2 à 50 mTorr, avantageusement de l'ordre de 10 mTorr.

La chimie de cette étape, notamment les conditions de température et de pression, ainsi que la nature des gaz constituant le plasma, sont déterminées en fonction des éléments en présence dans l'alliage, notamment de A et B. Le principe est que l'élément B placé dans ces conditions doit désorber plus facilement que les autres éléments (en particulier A) qui constitueront les billes.

En d'autres termes, le produit de réaction entre le(s) gaz et le deuxième matériau doit être plus volatil que le matériau conducteur électrique et même que le produit de réaction entre ce premier matériau et le(s) gaz formant le plasma.

A titre d'exemple, l'alliage InP, en présence des gaz C₂H₄ et H₂, forme de la phosphine (PH₃) très volatile. Dans des conditions similaires, le matériau GaAs mène à de l'arsine (AsH₃), elle aussi très volatile.

En faisant varier les paramètres du procédé selon l'invention, il est donc possible, à l'issue dudit procédé, d'obtenir des billes métalliques dans une gamme de taille très large, allant d'environ 10 micromètres à quelques dizaines de nanomètres. De manière notable par rapport à l'art antérieur (densité de l'ordre de 10⁶ billes/cm²), il est donc possible d'obtenir des billes de diamètre inférieur à 10 micromètres, voire inférieur à 3 micromètres, et présentant une densité importante, supérieure ou égale à 10⁷ billes/cm². Ainsi, les exemples de réalisation présentés ci-dessous montrent qu'il est possible d'obtenir, avec des billes plus petites, une densité supérieure ou égale à 10⁸ billes/cm².

En conclusion, la solution technique proposée dans le cadre de la présente demande offre plusieurs avantages :
- la possibilité de former des billes métalliques de taille micrométrique, voire nanométrique, à la surface d'un substrat en s'affranchissant de toute lithographie ;
- la possibilité de former des billes métalliques en densité élevée à la surface d'un substrat. Les billes sont bien séparées spatialement en X et Y dans le plan des couches, et permettent une conduction uniquement en Z soit perpendiculairement au plan des couches.
- la température maximale à laquelle doit être porté le substrat pour obtenir des billes métalliques peut être plus basse qu'avec une technique de fusion de matériau « massif ». En effet, la température de fusion des particules métalliques diminue avec la taille de ces particules. Lors de la gravure du matériau AB, il est possible que se forment, à l'échelle nanométrique, des particules A, qui fondent à température plus basse que la température de fusion de A massif, puis coalescent entre elles pour former de plus grosses particules allant jusqu'à des tailles micrométriques. Ainsi, pour les billes d'indium, il a été observé que les indicateurs de température n'ont pas relevé de températures supérieures à 130°C, alors que la température de fusion de l'indium est de 157°C.
   Comme déjà dit, la présente invention trouve de nombreuses applications d'intérêt :

- l'obtention d'ACA (« Anisotropic Conductive Adhesives ») ou d'ACF (« Anisotropic Conductive Films ») présentant un pas très fin ;
- l'hybridation par billes d'indium ;
- la réalisation de catalyseurs métalliques pour croissances de nanofils ;
- la réalisation de nanoparticules métalliques pour le domaine de la plasmonique.

### BREVE DESCRIPTION DES FIGURES

La manière dont l'invention peut être réalisée et les avantages qui en découlent ressortiront mieux des exemples de réalisation qui suivent, données à titre indicatif et non limitatif, à l'appui des figures annexées parmi lesquelles :
La figure 1 est une image par microscopie électronique à balayage montrant des billes d'indium pour le « flip-chip ».
La figure 2 est un schéma illustrant l'auto-alignement que permet la technique de « flip-chip » par billes d'indium, grâce à des étapes d'alignement visuel (A), de placement et de chauffage (B), suivis d'un auto-alignement (C).
La figure 3 schématise le mode de réalisation des billes d'indium selon l'art antérieur : (A) réception du circuit de lecture ; (B) métallurgie sous cordon de soudure ; (C) photolithographie définissant le volume d'indium ; (D) dépôt d'indium ; (E) dépôt localisé de résine photosensible ; (F) refonte d'indium.
La figure 4 schématise le mode de réalisation des billes d'indium selon l'invention comprenant une étape de dépôt du matériau AB (A) puis une étape de désorption de B parallèlement avec la formation de billes de A (B).
La figure 5 illustre des vues de dessus (A) ou de profil (B) prises par microscopie électronique à balayage, montrant l'obtention de billes à la surface d'un substrat d'InP, après gravure plasma ; la zone sans bille correspond au masque de gravure (nitrure).
La figure 6 correspond à des images en microscopie électronique à balayage qui montrent qu'en faisant varier les conditions de plasma, des billes de taille moyenne variable peuvent être obtenues (A : 0,2 µm; B : 1,8 µm; C : 3,2 µm; D : 6,5 µm).
La figure 7 correspond à une image obtenue en microscopie électronique à balayage de billes d'In d'environ 300 nm de diamètre obtenues par le procédé de l'invention à partir d'une couche de 3 µm d'InP collés sur du silicium via une couche de silice.
La figure 8 illustre les différentes étapes du procédé selon l'invention mis en oeuvre pour l'interconnexion de circuits avec un pas de billes très fin :
   ■ (A) définition des plots métalliques de connexion ;
   ■ (B) dépôt par CVD du matériau binaire AB ;
   ■ (C) gravure plasma avec un gaz favorisant la désorption de l'élément B ;
   ■ (D) mise en regard de l'élément à connecter et exercice d'une pression ;
   ■ (E) connexion réalisée.
La figure 9 illustre les différentes étapes du procédé selon l'invention mis en oeuvre pour obtenir des microbilles d'élément A à partir du binaire B :
   ■ (A) définition des plots métalliques qui recevront les billes métalliques ;
   ■ (B) dépôt par CVD du matériau binaire AB ;
   ■ (C) gravure plasma avec un gaz favorisant la désorption de l'élément B.
La figure 10 illustre une première variante du procédé de la figure 9, dans laquelle il n'y a pas besoin de plots métalliques pour assurer la conduction verticale.
La figure 11 illustre une seconde variante du procédé de la figure 9, permettant un meilleur contrôle de la fluctuation en taille des billes, dans laquelle une étape de lithographie avec dépôt de résine fine et une gravure chimique ou sèche sont mises en oeuvre (A) avant la gravure plasma (B).

### MODES DE REALISATION DE L'INVENTION

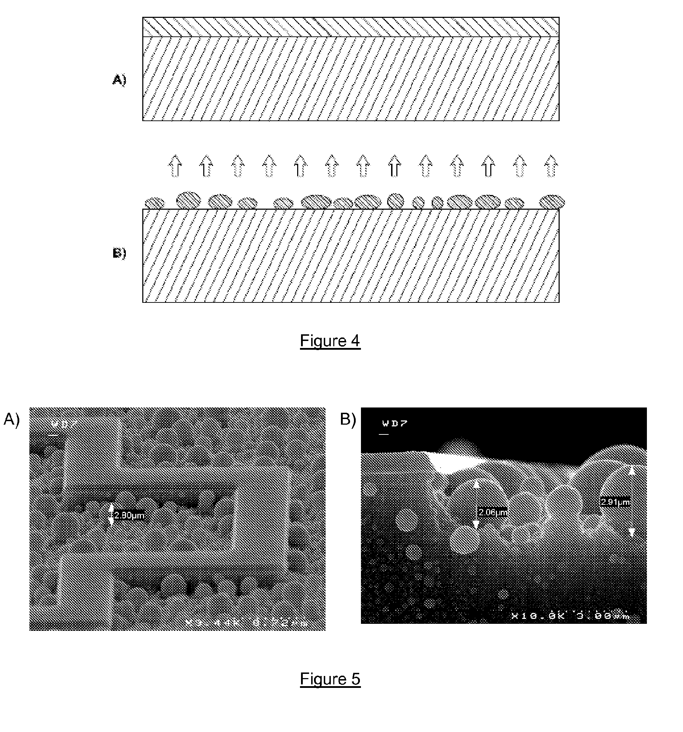

Le principe du procédé selon l'invention est illustré à la figure 4. Le mode de réalisation des billes d'indium décrit dans la présente demande implique deux étapes :
- une étape de dépôt de l'alliage AB (Fig. 4A) ;
- puis une étape de désorption de l'élément B et, en parallèle, la formation de billes d'élément A (Fig. 4B).
   Cette solution est illustrée concrètement sur l'image de microscopie électronique à balayage de la figure 5. Cette image a été réalisée dans le cadre de l'obtention de billes d'indium (In), qui joue ici le rôle de l'élément A.

Des substrats InP (qui joue ici le rôle du binaire AB), d'épaisseur quasi infinie de l'ordre de 350 µm, ont été soumis à une étape de gravure plasma en présence d'un mélange gazeux C₂H₄/H₂, dans un bâti de gravure ICP (« Inducely Coupled Plasma »). Les débits de gaz sont de l'ordre de 10 sccm pour l'éthylène, de 30 sccm pour l'hydrogène, la pression dans l'enceinte de gravure est de 10 mTorr, et les puissances RF et LF de 200W et 600W, respectivement.

L'hydrogène, qui est le gaz prépondérant dans l'enceinte, réagit préférentiellement avec le phosphore P pour former de la phosphine PH₃, très volatile : la désorption du phosphore est donc volontairement privilégiée, et ce à basse pression et basse température. L'indium restant se réorganise sous forme de nanobilles (2), dont la température de fusion est plus faible que la température de fusion de l'indium massif (157°C). Ces nanobilles coalescent pour former des billes de taille plus importante (figure 5).

Il est donc possible, à l'aide de cette technique, d'obtenir des billes d'indium à la surface d'un substrat sans utiliser de technique de photolithographie. Par ailleurs, on peut observer sur la figure 5 qu'il est possible d'obtenir des tailles de billes relativement petites, allant de 3 µm jusqu'à quelques dizaines de nm.

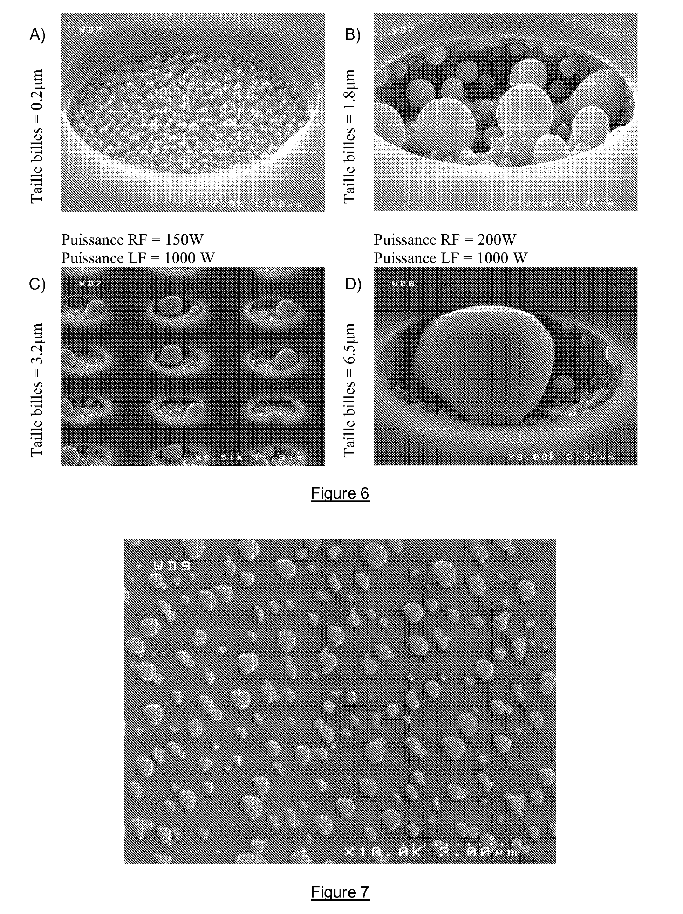

La figure 6 illustre le fait qu'il est possible de modifier la taille moyenne de ces billes d'indium, en jouant sur les conditions du plasma. Des substrats d'InP ont été exposés, pendant une durée de 15 minutes, à des plasmas C₂H₄/H₂ (10 sccm/30 sccm) sous une pression de 10 mTorr dans un bâti ICP. En faisant varier uniquement les puissances RF et LF, des tailles de billes comprises entre 0,2 et 6,5 µm ont été obtenues.

A la figure 7 est présenté le résultat de la gravure plasma d'une couche d'InP d'épaisseur finie de 3 µm, collée sur du silicium via une couche de silice :
l'homogénéité en taille de billes est meilleure par rapport aux gravures présentées précédemment, avec des diamètres de billes, pour les conditions de plasma utilisées, allant de 200 à 500 nm environ. La densité de billes est de l'ordre de 10⁸/cm².

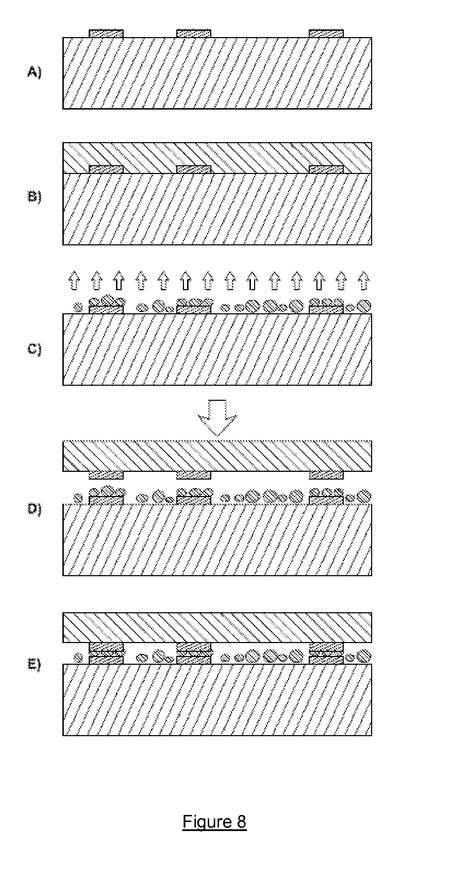

Comme déjà dit, une première application des billes obtenues à l'issue du procédé a trait à la réalisation de films conducteurs anisotropes (ACF pour « Anisotrop Conductive Films »). Un mode de réalisation adapté pour cette application est schématisé à la figure 8 et permet l'interconnexion de circuits avec un pas de billes très fin.

Cette figure illustre les étapes en amont et en aval du procédé selon l'invention :
- définition des plots métalliques de connexion (fig. 8A) ;
- dépôt par CVD du matériau binaire AB (fig. 8B) ;
- gravure plasma avec un gaz favorisant la désorption de l'élément B (fig.8 C) ;
- mise en regard de l'élément à connecter et exercice d'une pression (fig. 8D) aboutissant à la connexion (fig. 8E).
   Un second domaine d'application est la réalisation de champ de microbilles métalliques (« flip chip ») régulièrement espacées, mais avec un pas plus fin qu'avec la technique de « lift off » actuellement utilisée et telle qu'illustrée à la Figure 1.

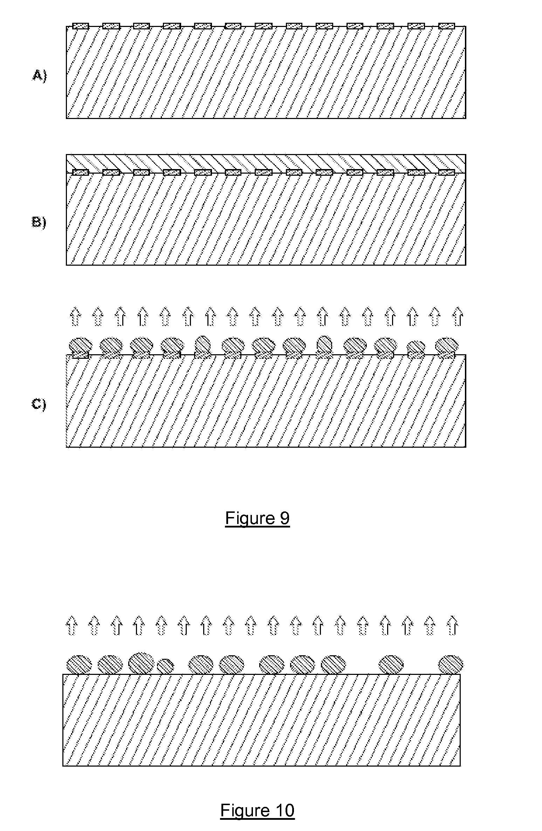

Dans ce cadre, un mode de réalisation possible, reposant sur le procédé selon l'invention, est décrit à la figure 9. Outre les deux étapes caractéristiques du procédé selon l'invention, une étape antérieure consiste à définir des plots métalliques destinés à recevoir des billes métalliques. Ces plots sont avantageusement espacés de quelques centaines de nm à quelques micromètres. De par la taille de ces plots, une seule bille est formée par plot à l'issue du procédé.

Une variante de ce mode de réalisation, proposée à la figure 10, consiste à s'affranchir des plots métalliques pour la conduction verticale. Selon le concept même du procédé de l'invention, les billes peuvent se former n'importe où sur le substrat, ce qui aboutit à une forte densité.

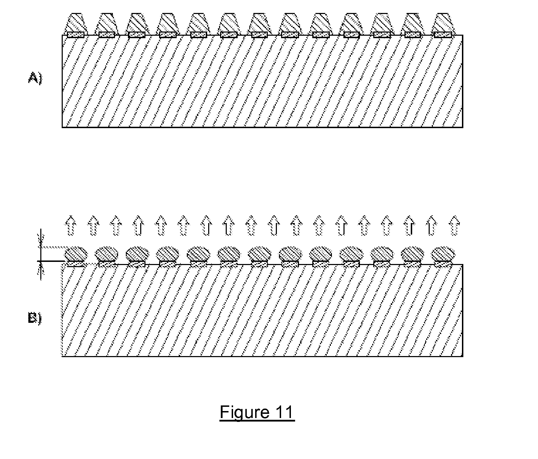

Afin de mieux maîtriser l'homogénéité en taille des billes, et pour une certaine gamme de diamètres de billes supérieure à 1 micromètre, il est possible de mettre en oeuvre une autre variante présentée à la figure 11. Celle-ci consiste à réaliser une étape de lithographie + gravure du matériau AB, avant la gravure plasma qui formera les billes. Toutefois, cette variante a l'inconvénient d'être plus lourde en termes de technologies mises en oeuvre.

### REFERENCES

(1) Kristiansen Helge et Liu Johan, « Overview of conductive Adhesive Interconnection Technologies for LCD's », IEE transactions on components, packaging, and manufacturing technology, part A, Vol. 21, N° 2, June 1998, pp 208-214.
(2) Coombes C.J., « The melting of small particles of lead and indium », J. Phys. F: Metal Phys., Vol. 2, May 1972, pp 441-449.

## Revendications

1. Procédé de fabrication de billes composées d'au moins un matériau conducteur électrique comprenant les étapes suivantes :
- dépôt, sur un support, d'un alliage comprenant au moins le matériau conducteur électrique et un second matériau ;
- exposition de l'alliage à une gravure plasma, de manière à entraîner la désorption des matériaux de l'alliage n'entrant pas dans la composition des billes, à savoir au moins le second matériau mais pas le matériau conducteur électrique ;
- formation de billes composées d'au moins ledit matériau conducteur électrique.

2. Procédé de fabrication de billes selon la revendication 1, ***caractérisé* en ce que** le premier matériau conducteur électrique et le second matériau sont choisis parmi les éléments des colonnes II et VI ou des colonnes III et V selon la classification périodique, respectivement.

3. Procédé de fabrication de billes selon la revendication 2, ***caractérisé* en ce que** le premier matériau conducteur électrique est de l'indium (In), du gallium (Ga) ou du cadmium (Cd), et le second matériau est du phosphore (P), de l'arsenic (As), ou du tellure (Te).

4. Procédé de fabrication de billes selon l'une des revendications précédentes, ***caractérisé* en ce que** l'alliage est ternaire ou quaternaire, comprenant un ou plusieurs matériaux conducteurs électriques.

5. Procédé de fabrication de billes selon l'une des revendications précédentes, ***caractérisé* en ce que** le dépôt de l'alliage sur le support est réalisé par dépôt chimique en phase vapeur (CVD).

6. Procédé de fabrication de billes selon l'une des revendications précédentes, ***caractérisé* en ce que** l'alliage déposé sur le support est mis en forme par lithographie et gravure, avant exposition à la gravure plasma.

7. Procédé de fabrication de billes selon l'une des revendications précédentes, ***caractérisé* en ce que** l'étape de gravure plasma est réalisée sous un vide de l'ordre de 2 à 50 mTorr, avantageusement de l'ordre de 10 mTorr.

8. Procédé de fabrication de billes selon l'une des revendications précédentes, ***caractérisé* en ce que** les gaz formant le plasma dans l'étape de gravure plasma sont l'éthylène (C₂H₄) et l'hydrogène (H₂).

9. Billes métalliques obtenues à l'aide du procédé selon l'une des revendications 1 à 8 présentant un diamètre inférieur à 10 micromètres, avantageusement inférieur à 3 micromètres.
